# FASCICULE DE BREVET EUROPEEN

(11) **EP 0 862 787 B1**
(45) Date de publication et mention de la délivrance du brevet: **03.01.2007**
(21) Numéro de dépôt: 97930597.6
(22) Date de dépôt: 26.06.1997
(51) Int. Cl.: H01L 21/762

(54) **PROCEDE D'ISOLATION LATERALE D'UNE REGION ACTIVE D'UN TRANSISTOR MOS**
VERFAHREN ZUR LATERALEN ISOLATION EINER AKTIVEN REGION EINES MOS TRANSISTORS
LATERAL INSULATING METHOD OF A MOS TRANSISTOR ACTIVE REGION

(30) Priorité: 27.06.1996 FR 9608008
(43) Date de publication de la demande: 09.09.1998
(73) Titulaire: COMMISSARIAT A L'ENERGIE ATOMIQUE, 75015 Paris (FR)
(72) Inventeur: DELEONIBUS, Simon, F-38640 Claix (FR)
(74) Mandataire: Audier, Philippe André
(86) Numéro de dépôt international: PCT/FR1997/001144
(87) Numéro de publication internationale: WO 1997/050122

(56) Documents cités:
- EP-A- 0 756 319
- US-A- 4 523 213
- US-A- 4 635 344
- PATENT ABSTRACTS OF JAPAN vol. 018, no. 022 (E-1490), 13 Janvier 1994 & JP 05 259418 A (NIPPON TELEGR & TELEPH CORP), 8 Octobre 1993,
- PROCEEDINGS OF THE EUROPEAN SOLID STATE DEVICE RESEARCH CONFERENCE (ESSDERC), NOTTINGHAM, SEPT. 10 - 13, 1990, no. CONF. 20, 10 Septembre 1990, ECCLESTON W;ROSSER P J, pages 13-16, XP000309143 LE NEEL O ET AL: "ROUNDED EDGE MESA FOR SUBMICRON SOI CMOS PROCESS"
- INTERNATIONAL CONFERENCE ON SOLID STATE DEVICES AND MATERIALS, 1995, pages 893-895, XP000609518 DELEONIBUS S ET AL: "INTERNATIONAL CONFERENCE ON SOLID STATE DEVICES AND MATERIALS" cité dans la demande
- PROCEEDINGS OF THE INTERNATIONAL SOI CONFERENCE, PONTE VEDRA BEACH, FL., OCT. 6 - 8, 1992, no. -, 6 Octobre 1992, INSTITUTE OF ELECTRICAL AND ELECTRONICS ENGINEERS, page 24/25 XP000529343 CROWDER S ET AL: "THERMAL OXIDATION KINETICS AND LOCOS ISOLATION IN SOI MATERIALS"

## Description

### Domaine technique

La présente invention concerne un procédé de préparation d'un substrat de type SOI pour y délimiter des régions actives de transistors MOS.

L'invention trouve des applications en microélectronique pour la fabrication de composants et de circuits intégrés rapides, ayant une faible consommation électrique.

### Etat de la technique antérieure

De façon générale, les transistors MOS rapides, de même que les transistors bipolaires rapides, nécessitent de fortes tensions d'alimentation et posent des problèmes par leur forte consommation en énergie électrique. Avec l'augmentation de la densité d'intégration la distance entre source et drain tend à diminuer. Ce phénomène engendre des courants de fuite entre la source et le drain des transistors MOS et ces courants altèrent par effet Joule la fiabilité des composants.

Les composants réalisés sur un substrat de type silicium sur isolant (SOI) permettent d'isoler la source et le drain du substrat et de réduire les capacités parasites, d'une part, entre la source et le substrat et, d'autre part, entre le drain et le substrat. Cette caractéristique autorise un fonctionnement des composants à fréquence élevée. Un dopage trop important sous les source et drain est également évité. Toutefois, les transistors MOS sur substrat SOI ont une consommation électrique importante due à des courants de fuite en régime de faible inversion, c'est-à-dire lorsque la tension qui leur est appliquée est faible et que le circuit à transistors est dans un état d'attente ou de veille. Un bruit important entre la source et le drain est par ailleurs généré.

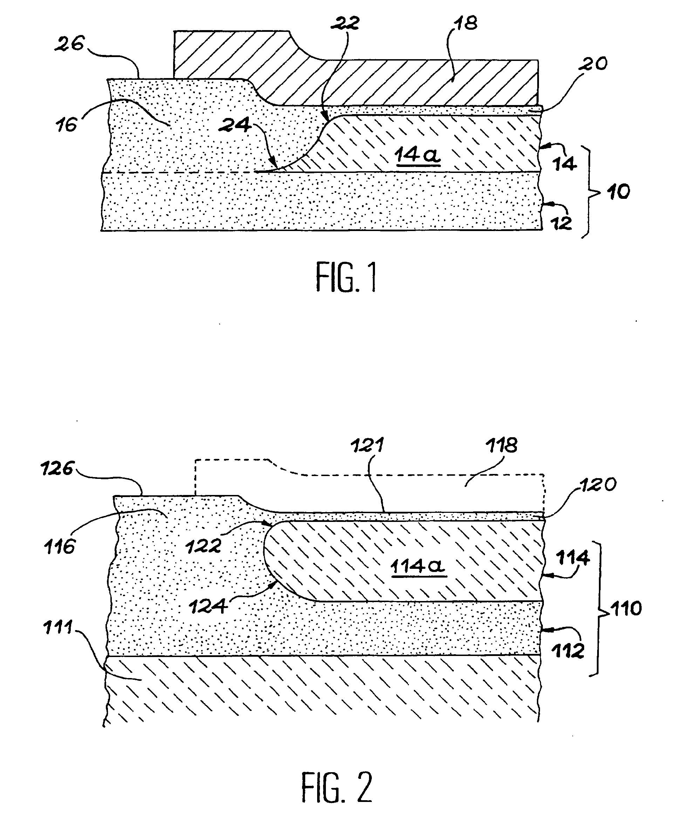

Les problèmes du contrôle de la caractéristique des transistors en faible inversion apparaissent plus clairement à la lecture de la figure 1.

La figure 1 montre en coupe un transistor MOS d'un type connu réalisé sur un substrat SOI.

Le transistor, vu en coupe transversale, est réalisé sur un substrat 10 SOI comprenant une couche d'oxyde de silicium enterrée 12 et un film superficiel de silicium 14. Une région active 14a du transistor est formée dans le film 14. Elle est latéralement délimitée par des pavés d'oxyde de silicium épais 16.

Pour simplifier la figure, et en raison de sa symétrie, un seul côté, et partant, un seul pavé 16 est représenté sur la figure 1.

Une grille 18, formée pour l'essentiel au-dessus de la région active 14a est séparée de celle-ci par une fine couche d'oxyde de grille 20. Les source et drain du transistor ne sont pas contenus dans le plan de coupe de la figure 1 et n'y apparaissent donc pas.

Les problèmes du contrôle de la caractéristique en faible inversion d'un transistor conforme à la figure 1 sont liés à trois phénomènes principaux.

Le premier phénomène correspond au partage de charges entre le canal lui-même et le flanc du transistor. Un deuxième phénomène est un perçage entre la source et le drain .du transistor. Enfin, un troisième phénomène, décrit ci-dessous, est la fuite de courants par le "fond" de la région active.

Les deux premiers phénomènes sont classiques et apparaissent également pour des transistors MOS réalisés sur un substrat de silicium massif.

Les problèmes de contrôle liés à ces deux phénomènes peuvent être résolus en jouant sur le dessin et un dopage des flancs du transistor et par une conception appropriée des régions de source et de drain. On peut, par exemple, implanter les sources et drains de façon à ce qu'ils présentent un profil graduel en diminuant la diffusion latérale sous la grille (LDD). On peut se reporter à ce sujet au document (1) dont la référence est indiquée à la fin de la présente description.

Le troisième phénomène est spécifique aux transistors MOS réalisés sur un substrat SOI. Il convient de préciser que la fuite de courant par le "fond" de la région active comprend à la fois une fuite directement entre la région active 14a et la couche enterrée d'oxyde de silicium 12 et une fuite sur le bord de la région active à l'interface entre la couche active 14a, le pavé d'oxyde de silicium 16 et la couche enterrée 12.

Cette interface est désignée dans la suite du texte par "coin inférieur" et est repérée par la référence 24 sur la figure 1.

La fuite engendrée directement à l'interface entre la région 14a et la couche 12 peut être contrôlée par un choix d'une qualité du matériau et son procédé d'élaboration. On peut se reporter à ce sujet au document (2) cité à la fin de la présente description.

Par contre, la fuite engendrée dans le coin inférieur 24 est plus difficile à contrôler. Elle est due, au moins en partie, à un défaut d'impuretés dopantes dans ce domaine de très petit volume de la région active.

Les cotes en épaisseur du coin 24 sont comprises entre 0 nm à quelques 10 nm.

Or, pour une région active dont la concentration de dopage est de l'ordre de 10¹⁸ at.cm⁻³, le nombre d'atomes moyen effectivement présent dans un domaine d'une section 10 nmx10 nm est inférieur à 1.

Par conséquent, pour des concentrations de dopage de la région active plus faible, il est probable qu'aucun atome d'impureté dopante ne soit présent dans un volume donné du coin inférieur 24 de silicium. Ainsi, le silicium du coin inférieur 24, sous le pavé d'oxyde de silicium épais 16, est sensiblement intrinsèque.

Ce phénomène est encore renforcé pour des transistors à enrichissement avec un canal de type n dopé avec du bore. En effet, le coefficient de diffusion du bore dans l'oxyde de silicium est supérieur à son coefficient de diffusion dans le silicium. Ainsi une région confinée de silicium, de très petit volume, et entourée d'oxyde de silicium tend encore davantage à s'appauvrir en impuretés dopantes. Dans cette région, le contrôle de la charge d'espace est par conséquent difficile et une fuite de courant par le coin 24 peut se produire.

Le document JP 05259418 décrit un procédé de préparation d'un substrat de type SOI dans lequel on recouvre une portion superficielle du silicium avec une couche masquante, et on effectue une oxydation locale de la couche superficielle du silicium pour former des pavés d'oxyde d'isolation.

Selon l'enseignement du document (1) dont la référence est indiquée à la fin de la présente description, il est également connu que le coin supérieur de la région active 14a formé à l'intersection de la couche 14, de la couche d'oxyde de grille 20 et du pavé d'oxyde de silicium épais 16 doit de préférence être arrondi. Sur la figure 1, ce coin est indiqué avec la référence 22.

L'arrondi du coin supérieur 22 permet de contrôler la divergence des lignes de champ dans la partie semi-conductrice et d'éviter ainsi une extension mal contrôlée de la zone de charge d'espace de la région active polarisée.

Pour obtenir un coin supérieur arrondi sur la couche active, il est connu de former les pavés d'oxyde épais 16 selon un procédé d'oxydation à haute température.

L'oxydation à haute température est décrite dans les documents (3) et (4) dont les références sont indiquées à la fin de la présente description.

Le traitement à haute température pour arrondir le coin supérieur de la région active est connu pour la réalisation de transistors sur un substrat de silicium massif et repose sur le principe du fluage de l'oxyde de silicium. Un tel traitement n'est par conséquent envisageable que pour arrondir un coin supérieur de la structure, c'est-à-dire qui affleure librement à sa surface. On peut noter également, qu'a priori, pour des substrats de type SOI un tel traitement à haute température peut avoir des effets négatifs en provoquant la migration des impuretés de dopage de la région active.

Par ailleurs, on sait qu'il est avantageux de prévoir un surplomb avec une marche positive entre la surface 26 du pavé d'oxyde épais et la surface 28 de l'oxyde de grille.

Cette marche positive permet d'éviter un risque de couplage parasite de la grille du transistor avec le flanc de la zone active. Ce couplage peut engendrer une fuite.

On peut se reporter à ce sujet aux documents (1) et (5) dont la référence est indiquée à la fin de la présente description.

### Exposé de l'invention

Un but de la présente invention est de proposer un procédé de préparation d'un substrat de type SOI pour y délimiter des régions actives d'un transistor ne souffrant pas des limitations évoquées ci-dessus.

Plus précisément un but est de conformer la région active de façon à obtenir un contrôle total des courants de fuite en régime de faible inversion, c'est-à-dire lorsque le transistor est en-dessous du seuil de conduction.

En particulier, un but est de réduire de façon importante les fuites de courant à l'interface des bords inférieurs de la région active, des oxydes épais d'isolation délimitant latéralement la région active, et de la couche d'oxyde enterrée.

On propose aussi un transistor, qui ne fait pas partie de l'invention, présentant une faible consommation d'énergie au repos, c'est-à-dire avec des courants de fuite réduits.

Ledit transistor est plus précisément un transistor à effet de champ de type MOS comprenant une portion de couche de silicium, formant une région active, disposée entre une couche d'oxyde de grille et une couche d'oxyde enterrée, et délimitée latéralement par des pavés d'oxyde d'isolation latérale. La portion de couche de silicium présente des bords concaves tournés vers les pavés d'oxyde d'isolation latérale.

On considère que les bords de la région active sont concaves lorsque l'extrémité supérieure des bords, adjacente à la couche d'oxyde de grille, et l'extrémité inférieure des bords, adjacente à la couche d'oxyde enterrée, sont arrondies.

En particulier, le coin inférieur saillant de la région active, s'étendant entre la couche d'oxyde enterrée et le pavé d'oxyde d'isolation, tel que décrit précédemment, est éliminé dans la structure du ledit transistor.

Pour des raisons de commodité, le bord de la couche active adjacent à la couche d'oxyde de grille et le bord de la couche active adjacent à la couche d'oxyde enterrée sont respectivement désignés par "coin supérieur" et "coin inférieur" dans la suite du texte.

Le caractère concave des bords de la couche active exclut l'existence de régions confinées de silicium intrinsèque de petit volume. Les courants de fuite sont par conséquent évités.

On peut noter enfin que pour des transistors à canal n, dopé au bore, le phénomène de diffusion de l'impureté dopante (bore) vers les régions d'oxyde de silicium devient marginal.

Selon un aspect particulier avantageux, les pavés d'oxyde d'isolation peuvent former un surplomb à marche positive par rapport à la couche d'oxyde de grille.

Le surplomb à marche positive est considéré entre la surface des pavés d'oxyde d'isolation et la surface de la couche d'oxyde de grille.

L'invention a pour objet un procédé de préparation d'un substrat de type SOI selon la revendication 1.

Comme dans le cas des dispositifs à transistors MOS classiques sur substrat massif , l'oxydation à haute température permet, par un phénomène de fluage de l'oxyde de silicium des pavés d'isolation latérale, d'arrondir le coin supérieur du bord de la région active.

Cependant, dans le cadre de l'invention dans son application à la préparation de substrats SOI, l'oxydation a une autre fonction pour l'arrondissement du coin inférieur du bord de la région active.

Il convient de préciser que l'arrondissement du coin inférieur ne peut pas être obtenu par un fluage en raison du fait que le coin inférieur n'apparaît pas à la surface de la structure.

La fonction de l'oxydation thermique à haute température dans le cadre de l'invention est d'augmenter la diffusion des atomes interstitiels de silicium.

On entend par atomes interstitiels des atomes de silicium qui ont quitté leur position de valence dans le réseau de silicium, par exemple sous l'effet d'une agitation thermique.

Les inventeurs ont en effet découvert que dans le cas particulier de préparation de substrats SOI avec une couche superficielle mince, l'augmentation de la température d'oxydation permet la diffusion d'atomes de Si, vers le coin inférieur du bord de la région active. Ces atomes, qui proviennent pour l'essentiel de la couche sous-jacente de silicium, peuvent être alors oxydés. Il en résulte que le coin inférieur de silicium est arrondi.

Pour augmenter la diffusion des atomes interstitiels de silicium, on augmente leur coefficient de diffusion en élevant la température d'oxydation des pavés d'oxyde d'isolation. Cependant, selon un aspect avantageux de l'invention, on peut aussi effectuer une oxydation à température élevée et à haute pression. L'augmentation de la pression permet en effet d'accroître la densité d'atomes de silicium interstitiels disponibles.

L'ambiance d'oxydation, et en particulier une atmosphère de vapeur d'eau, favorise la diffusion d'atomes de silicium interstitiels provenant de la couche de silicium sous-jacente, à travers la couche enterrée d'oxyde de silicium. L'atmosphère humide augmente aussi le coefficient de diffusion de groupes OH à travers l'oxyde déjà formé et accélère par conséquent la vitesse d'oxydation à l'interface Si/SiO₂ du bord inférieur de la couche active.

L'oxydation par voie humide est précédée d'une première étape d'oxydation par voie sèche.

L'oxydation par voie sèche est plus sélective par rapport au masque de nitrure de silicium et limite la formation d'un "bec d'oiseau" (bird's beak) par oxydation du nitrure de silicium et oxydation du silicium sous-jacent de la couche de nitrure.

Selon un autre aspect avantageux de l'invention, on peut effectuer un dopage de la région active après l'oxydation à haute température. Un tel dopage, a priori inefficace pour des structures classiques à caissons, est possible en raison du caractère relativement fin du film superficiel de silicium.

Le dopage postérieur à l'oxydation, permet d'éviter une migration à haute température des impuretés dopantes.

D'autres caractéristiques et avantages de l'invention apparaissent dans la description qui suit, en référence aux figures des dessins annexés, donnée à titre purement illustratif et non limitatif.

### Brève description des figures

- la figure 1, déjà décrite, est une coupe schématique transversale partielle d'un transistor connu, avec une isolation latérale par des pavés d'oxyde de silicium, sur un substrat SOI,
- la figure 2 est une coupe schématique transversale partielle d'un substrat et d'un transistor qui ne fait pas partie de l'invention,
- les figures 3, 4 et 5 sont des coupes schématiques transversales partielles d'un substrat SOI et illustrent des étapes de préparation de ce substrat conformément à une mise en oeuvre du procédé de l'invention.

### Modes de mise en oeuvre de l'invention

La figure 2 montre en coupe une partie d'un substrat et d'un transistor qui ne fait pas partie de l'invention.

En raison de la similitude d'un certain nombre d'éléments avec la figure 1, les éléments identiques ou similaires de la figure 2 portent la même référence à laquelle on a ajouté 100.

Le transistor de la figure 2 est réalisé sur un substrat SOI 110 comportant une couche sous-jacente de support 111 en silicium, une couche enterrée d'oxyde de silicium 112 et un film mince de silicium superficiel 114. Dans le film superficiel 114, une ou plusieurs régions actives 114a sont délimitées par des pavés d'oxyde de silicium 116 formant une isolation latérale. Les pavés 116 sont formés par oxydation locale. On note que sur la figure 2, seule une partie de région active 114a et une partie d'un pavé d'oxyde 116 sont représentés.

On indique avec les références 122 et 124 respectivement le coin supérieur et le coin inférieur du bord de la région active tournée vers le pavé d'oxyde 116.

Une couche d'oxyde de silicium, formant oxyde de grille 120, sépare la région active 114a de la grille 118, représentée à titre purement indicatif par un trait discontinu.

En raison du plan de coupe transversal de la région active, les drain et source du transistor ne sont pas contenus dans le plan de la figure. De la même façon, et pour des raisons de simplification, les prises de connexion sur les bornes du transistor sont omises.

La région active 114a du transistor est une portion de la couche de silicium 114 présentant des bords concaves tournés vers le pavé 116. Le caractère concave du bord se traduit par des coins supérieur 122 et inférieur 124 arrondis.

Le pavé d'oxyde de champ 116 s'étend dans le film mince superficiel sur toute son épaisseur pour venir se confondre avec la couche enterrée 112 d'oxyde de silicium.

La figure 2 montre également un surplomb à marche positive entre la surface libre 126 du pavé d'oxyde 116 et la surface 121 de la couche d'oxyde de grille 120, en contact avec la grille 118.

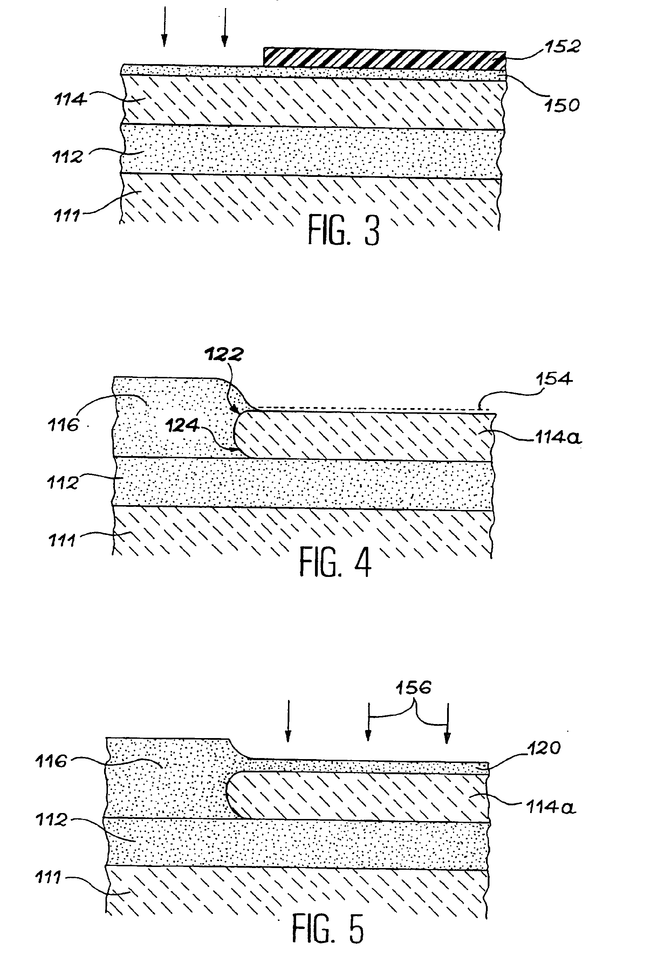

On se réfère aux figures 3, 4 et 5 pour la description d'une mise en oeuvre du procédé de préparation du substrat selon l'invention. Des éléments identiques ou similaires à ceux de la figure 2 portent les mêmes références.

Comme le montre la figure 3, on part d'un substrat de type SOI avec une couche de silicium 111 dite sous-jacente, une couche enterrée d'oxyde de silicium 112 et un film superficiel 114.

Dans une première étape on forme par oxydation une fine couche 150 d'oxyde de silicium à la surface du film 114. La couche 150, dite couche piédestal permet de limiter la contrainte induite, lors de l'oxydation locale, sur la zone active.

Sur la couche 150, on forme une couche de nitrure de silicium. Celle-ci est mise en forme avec des procédés de photolithographie, connus en soi, pour définir un ou plusieurs motifs 152 qui recouvrent des parties du substrat SOI correspondant aux futures régions actives. Dans la suite du texte, on ne fait référence qu'à un seul motif 152. Toutefois, une pluralité de tels motifs permet de définir simultanément plusieurs régions actives. Après élimination d'un éventuel masque de résine ayant servi à former le motif 152, on procède à une oxydation locale du substrat pour y définir des pavés épais d'oxyde de silicium.

On réalise dans l'exemple décrit l'oxydation en deux étapes distinctes dans les régions non protégées par le nitrure de silicium.

Une première étape comporte une oxydation en ambiance sèche sous atmosphère O₂ avec du HCl. Cette oxydation sèche limite l'oxydation du motif de nitrure de silicium 152 et par conséquent limite l'extension du bec d'oiseau, c'est-à-dire la déformation de la surface du substrat apparaissant au bord du motif de nitrure 152. En effet, le nitrure de silicium s'oxyde beaucoup moins vite en atmosphère sèche qu'en atmosphère humide.

Une deuxième étape d'oxydation est conduite en atmosphère humide avec un mélange O₂ et H₂. Cette deuxième étape permet d'arrondir plus facilement les coins 122, 124 de la région active 114a, et en particulier le coin inférieur 124. Ceci apparaît sur la figure 4.

Les oxydations sont effectuées à une température comprise de préférence entre 1000°C et 1200°C et à une pression comprise de préférence entre 10⁵ et 10⁷ Pa.

Après l'oxydation, on élimine la couche de nitrure, partiellement oxydée, formant le motif 152, et la couche de piédestal dans la région active 114a qui est maintenant définie et délimitée par des pavés d'oxyde épais. Un seul de ces pavés 116 est visible sur la figure 4.

De façon accessoire, on peut nettoyer la surface de la région active 114a en y formant par oxydation une fine couche 154 d'oxyde sacrificiel puis en éliminant cette couche. La couche d'oxyde sacrificiel 154 est représentée en trait discontinu sur la figure 4.

Le substrat est alors prêt pour y fabriquer un ou plusieurs transistors dans les régions actives.

Comme le montre la figure 5, la préparation du substrat peut être complétée par le dopage 156 par implantation des régions actives 114a avec des atomes de Bore (canal N) et la formation d'une couche d'oxyde de grille 120 sur la région active. Le dopage de la région active à ce stade du procédé permet de soustraire les impuretés de dopage aux effets de la température élevée de l'oxydation.

Pour réaliser un transistor, une grille, des régions de source et de drain, non représentées sur la figure 5, sont ensuite fabriquées selon des techniques connues en soi.

On obtient un transistor tel que représenté à la figure 2 déjà décrite.

Un tel transistor a l'avantage d'être rapide et d'avoir une faible consommation au repos en raison de la limitation des courants de fuite au bord de la région active.

### DOCUMENTS CITES

*(1)*
   A Post Gigabit Generation Flash Memory Shallow Trench Isolation Scheme. The LATI-STI Process (LArge Tilt Implanted Sloped Trench Isolation) Using 100% CMP Planarization. De S. DELEONIBUS et al., Extended Abstracts of the 1995 International Conference on Solid State Devices and Materials, Osaka, 1995, pp-587-589
*(2)*
   Microstructures of silicon implanted with high dose oxygen ions de C. Jaussaud et al. Appl. Phys. Lett., 46(11), 1 june 1985, p. 1064-1066
*(3)*
   A High Pressure High Temperature Poly Buffer LOCOS (HP-HTPBL) Isolation Process for 1Gbit Density Non Volatile Memories de S. DELEONIBUS et al., Extended Abstracts of the 1995 International Conference on Solid State Devices and Materials, Osaka, 1995, pp.893-895.
*(4)*
   High Pressure Oxidation of Silicon in Dry Oxygen de Liang N. Lie et al., J. Electrochem Soc : Solid-state Science and Technology December 1982, pages 2828-2834.
*(5)*
   "Trench Isolation for 0.45 µm Active Pitch and Below" de Asanga H. Perera, et al., IDEM 95, pages 679-682.

## Revendications

1. Procédé de préparation d'un substrat de type SOI comportant une couche de silicium dite sous-jacente (111), une couche d'oxyde de silicium dite enterrée (112) et un film mince superficiel de silicium (114), pour délimiter au moins une région active (114a) de transistor dans le film superficiel de silicium avec des pavés d'oxyde d'isolation latérale (116), dans lequel :
- on recouvre respectivement une portion du film superficiel correspondant à chaque région active avec une couche de nitrure de silicium (152), et
- on effectue une oxydation locale de la couche superficielle de silicium dans des régions non-recouvertes par la couche de nitrure de silicium pour former les pavés d'oxyde d'isolation,
dans lequel ladite oxydation locale est une oxydation à haute température et qu'elle comporte une première étape d'oxydation par voie sèche et une deuxième étape d'oxydation sous vapeur d'eau.

2. Procédé selon la revendication 1, **caractérisé en ce que** l'oxydation locale est à haute pression.

3. Procédé selon la revendication 1, **caractérisé en ce qu'**on effectue l'oxydation locale à une température comprise entre 1000°C et 1200°C.

4. Procédé selon la revendication 2, **caractérisé en ce qu'**on effectue l'oxydation locale à une pression comprise entre 10⁵ Pa et 10⁷ Pa.

5. Procédé selon la revendication 1, **caractérisé en ce qu'**il comporte en outre une étape de dopage de la région active (114a), l'étape de dopage étant effectuée après l'oxydation à haute température.

6. Procédé selon la revendication 1, **caractérisé en ce qu'**avant de recouvrir la région active avec la couche de nitrure de silicium (152), on forme à la surface du film mince de silicium une fine couche (150) d'oxyde de silicium dite couche piédestal, la couche piédestal et la couche de nitrure de silicium étant éliminées après l'oxydation locale.

7. Procédé selon la revendication 5, **caractérisé en ce qu'**il comporte en outre après l'oxydation locale, l'élimination de la couche de nitrure de silicium sur chaque région active et le nettoyage d'une surface de chaque région active ainsi mise à nu.

8. Procédé selon la revendication 7, **caractérisé en ce que** le nettoyage de la surface de chaque région active comporte une oxydation de la surface pour former une couche sacrificielle d'oxyde de silicium, puis l'élimination de ladite couche sacrificielle.

9. Procédé de réalisation d'un transistor MOS selon lequel :
- on délimite une région active (114a) du transistor sur un substrat de type SOI,
- on forme une couche d'oxyde de grille (120) puis une grille (118) au-dessus de la région active, et
- on forme des régions de drain et de source dans la région active de part et d'autre de la grille.
**caractérisé en ce qu'**on délimite la région active conformément au procédé de l'une des revendications 1 à 8.

## Claims

1. Process for the preparation of an SOI-type substrate comprising a subjacent silicon layer (111), a buried silicon oxide layer (112) and a thin silicon surface film (114), for delimiting at least a transistor active region (114a) in the silicon surface film with lateral insulation oxide blocks (116) wherein:
- a portion of the surface film corresponding to each active region is respectively covered with a silicon nitride layer (152), and
- the silicon surface layer is oxidized locally in regions not covered by the silicon nitride layer to form the insulation oxide blocks,
wherein said local oxidation is high-temperature oxidation and it includes a first oxidation step using a dry method and a second oxidation step under steam.

2. Process according to Claim 1, **characterized in that** the local oxidation is at high pressure.

3. Process according to Claim 1, **characterized in that** the local oxidation is carried out at a temperature of between 1,000°C and 1,200°C.

4. Process according to Claim 2, **characterized in that** the local oxidation is carried out at a pressure of between 10⁵ Pa and 10⁷ Pa.

5. Process according to Claim 1, **characterized in that** it additionally includes a step of doping of the active region (114a), the doping step being carried out after the high-temperature oxidation.

6. Process according to Claim 1, **characterized in that** prior to covering the active region with the silicon nitride layer (152) there is formed at the surface of the thin silicon film a fine silicon oxide layer (150) known as the pedestal layer, the pedestal layer and the silicon nitride layer being removed after the local oxidation.

7. Process according to Claim 5, **characterized in that** it additionally includes, after the local oxidation, the removal of the silicon nitride layer from each active region and the cleaning of a surface of each active region thus exposed.

8. Process according to Claim 7, **characterized in that** the cleaning of the surface of each active region includes oxidation of the surface to form a sacrificial silicon oxide layer, then removal of said sacrificial layer.

9. Process for producing a MOS transistor in accordance with which:
- an active region (114a) of the transistor is delimited on an SOI-type substrate,
- there is formed a gate oxide layer (120) then a gate (118) above the active region, and
- drain and source regions are formed in the active region either side of the gate,
**characterized in that** the active region is delimited in accordance with the process of any one of Claims 1 to 8.

## Patentansprüche

1. Verfahren zur Herstellung eines Substrats des SOI-Typs mit einer sogenannten Unterschicht (111), einer sogenannten vergrabenen Siliciumdioxidschicht (112) und einem dünnen Siliciumoberflächenfilm (114), um in dem Siliciumoberflächenfilm wenigstens einen aktiven Transistorbereich (114a) mit Seitenisolationsoxidblöcken (116) abzugrenzen,
bei dem:
- man jeweils einen jedem aktiven Bereich entsprechenden Teil des Oberflächenfilms mit einer Siliciumnitridschicht (152) abdeckt, und
- man eine lokale Oxidation der Siliciumoberflächenschicht in nicht durch die Siliciumnitridschicht abgedeckten Bereichen realisiert, um die Isolationsoxidblöcke zu bilden, und bei dem die genannte lokale Oxidation eine Hochtemperaturoxidation ist, mit einem ersten Schritt zur Trockenoxidation und einem zweiten Schritt zur Oxidation unter Wasserdampf.

2. Verfahren nach Anspruch 1, **dadurch gekennzeichnet, dass** man die lokale Oxidation mit einem hohen Druck durchführt.

3. Verfahren nach Anspruch 1, **dadurch gekennzeichnet, dass** man die lokale Oxidation bei einer Temperatur zwischen 1000 °C und 1200 °C durchführt.

4. Verfahren nach Anspruch 2, **dadurch gekennzeichnet, dass** man die lokale Oxidation mit einem Druck zwischen 10⁵ Pa und 10⁷ Pa durchführt.

5. Verfahren nach Anspruch 1, **dadurch gekennzeichnet, dass** es außerdem einen Schritt zum Dotieren des aktiven Bereichs (114a) umfasst, wobei der Dotierschritt nach der Hochtemperaturoxidation durchgeführt wird.

6. Verfahren nach Anspruch 1, **dadurch gekennzeichnet, dass** man vor dem Abdecken des aktiven Bereichs mit der Siliciumnitridschicht (152) an der Oberfläche des dünnen Siliciumfilms eine Sockelschicht genannte dünne Siliciumdioxidschicht (150) ausbildet, wobei die Sockelschicht und die Siliciumnitridschicht nach der lokalen Oxidation eliminiert werden.

7. Verfahren nach Anspruch 5, **dadurch gekennzeichnet, dass** es außerdem nach der lokalen Oxidation die Eliminierung der Siliciumnitridschicht auf jedem aktiven Bereich und die Reinigung einer Oberfläche jedes derart freigelegten aktiven Bereichs umfasst.

8. Verfahren nach Anspruch 7, **dadurch gekennzeichnet, dass** die Reinigung der Oberfläche jedes freigelegten aktiven Bereichs eine Oxidation der Oberfläche umfasst, um eine Siliciumdioxid-Opferschicht auszubilden; dann Eliminierung der genannten Opferschicht.

9. Verfahren zur Herstellung eines MOS-Transistors, bei dem:
- man einen aktiven Bereich (114a) des Transistors auf einem Substrat des SOI-Typs abgrenzt,
- man eine Gateoxidschicht (120) und dann ein Gate (118) über dem aktiven Bereich ausbildet, und
- man beiderseits des Gates in dem aktiven Bereich Drain- und Sourcebereiche bildet;
**dadurch gekennzeichnet, dass** man den aktiven Bereich entsprechend dem Verfahren nach einem der Ansprüche 1 bis 8 abgrenzt.
